(19) **Europäisches Patentamt**

**European Patent Office**

**Office européen des brevets**

(11) Numéro de publication : **0 131 482**
**B1**

(12) **FASCICULE DE BREVET EUROPÉEN**

(45) Date de publication du fascicule du brevet :
30.09.87

(51) Int. Cl.⁴ : **G 11 C 19/08**

(21) Numéro de dépôt : **84401063.7**

(22) Date de dépôt : **23.05.84**

(54) **Dispositif de propagation de bulles magnétiques.**

(30) Priorité : **30.05.83 FR 8308913**

(43) Date de publication de la demande :
**16.01.85 Bulletin 85/03**

(45) Mention de la délivrance du brevet :
**30.09.87 Bulletin 87/40**

(84) Etats contractants désignés :
**DE GB NL**

(56) Documents cités :
**EP-A- 0 038 754**
**US-A- 4 023 150**
**US-A- 4 162 537**

(73) Titulaire : **COMMISSARIAT A L'ENERGIE ATOMIQUE Etablissement de Caractère Scientifique Technique et Industriel**
**31/33, rue de la Fédération**
**F-75015 Paris (FR)**

(72) Inventeur : **Pougnet, Philippe**
**15, rue du Vieux Moulin**
**F-78370 Plaisir (FR)**

(74) Mandataire : **Mongrédien, André et al**
**c/o BREVATOME 25, rue de Ponthieu**
**F-75008 Paris (FR)**

## Description

La présente invention, due aux travaux de Monsieur philippe POUGNET du Centre National d'Etudes Spatiales (CNES), concerne un dispositif de propagation de bulles magnétiques. Elle s'applique à la circulation d'informations binaires ou bits, matérialisées sous la forme de domaines magnétiques isolés qualifiés de bulles dans une mémoire à bulles ; ces domaines présentent une aimantation inverse de celle du reste du matériau magnétique qui constitue la couche dans laquelle ils sont formés.

On sait que dans une mémoire à bulles magnétiques, chaque bulle peut être déplacée par une force ; ce mouvement peut s'effectuer librement dans n'importe quelle direction, dans le plan de la couche magnétique. La couche magnétique est un grenat magnétique et les bulles sont formées dans cette couche en lui appliquant un champ magnétique continu, perpendiculaire au plan de la couche. Ce champ est produit dans la pratique, par un aimant permanent ; il assure en outre, la non volatilité des informations contenues dans la mémoire.

La couche de grenat magnétique dans laquelle sont formées les bulles, est généralement supportée par un grenat monocristallin amagnétique.

Il est connu de déplacer les bulles, grâce à l'application d'un champ magnétique tournant difficile à mettre en œuvre et dont le rôle est de créer des pôles, sur des motifs en permalloy par exemple, qui présentent la forme de barres en T, en chevrons, ou la forme de demi-disques : on réalise ainsi des registres à décalages dans lesquels l'information binaire est représentée par la présence « 1 », ou l'absence « 0 » d'une bulle. En plus de ces motifs en permalloy, on sait qu'il est nécessaire d'utiliser des conducteurs électriques pour réaliser sur la puce de mémoire à bulles, des fonctions d'écriture, d'enregistrement de l'information, de lecture non destructive, de transferts de registre à registre, et d'effacement. L'effacement est réalisé bit par bit par destruction sélective des bulles, ou globalement. Cet effacement est obtenu très simplement en augmentant la valeur du champ magnétique continu, au-delà de la valeur maximum permise pour l'enregistrement.

On sait aussi qu'un grand nombre de mémoires à bulles, de type connu, comprennent une couche de grenat magnétique dans laquelle on réalise une implantation ionique autour de motifs correspondant à des zones non implantées de cette couche de grenat. Ces motifs constituent, par leur forme, des registres à décalage le long desquels les bulles peuvent circuler dans la zone implantée. Les bulles magnétiques sont formées dans la couche de grenat, dans la partie implantée de celle-ci, sur les pourtours des motifs non implantés. Ces motifs ont généralement une forme allongée et la lecture ou le transfert du .contenu des registres est généralement effectué en faisant circuler les bulles parvenant à leurs extrémités, vers un autre registre ou vers une station de lecture. Cette circulation des bulles aux extrémités des registres est assurée généralement par des feuilles conductrices superposées à la couche de grenat magnétique, aux extrémités des registres et représentant des fenêtres. Ces feuilles sont parcourues par des courants impulsionnels qui amènent les bulles parvenues aux extrémités des registres, soit vers un autre registre, soit vers la station de lecture. Cette circulation est obtenue grâce à l'apparition de pôles positifs et négatifs apparaissant sur les bords des fenêtres au moment où une impulsion de courant est appliquée à la feuille conductrice correspondante. Généralement, ces fenêtres sont disposées parallèlement entre elles, perpendiculairement à une ligne correspondant à la direction selon laquelle les bulles doivent être acheminées. Le passage de chaque bulle du bord d'une fenêtre au bord d'une autre fenêtre s'effectue dans la couche de grenat magnétique, par simple attraction de cette bulle due à des polarités convenables des bords des fenêtres. Ce type de circulation des bulles aux extrémités de registres d'une mémoire à bulles est décrit par exemple dans le document EP-A-38 754 au non du même demandeur.

On connaît également une mémoire à bulles dans laquelle la propagation des bulles est assurée à l'aide d'un dispositif comprenant une feuille électriquement conductrice présentant des fenêtres, associée à des îlots non implantés de la couche de grenat magnétique. Ce type de propagation est décrit dans l'article de A. H. BOBECK intitulé « Current access magnetic bubble circuits » Bell laboratories - 600 Mountain Avenue — Murray Hill — New Jersey, Revue « Bell System Technical Journal » vol. 58, n° 6, juillet 1979.

Dans ce type de propagation, comme dans celui qui est décrit dans la demande de brevet précitée, les bulles magnétiques sont accrochées à la bordure de l'îlot non implanté, dans la région implantée. Au cours de leurs déplacements par un champ vertical créé par un courant dans la feuille, les bulles ont à franchir la barrière de potentiel existant à la bordure de ces motifs non implantés. Un champ plan statique unidirectionnel de $16{,}70 \cdot 10^3$ A/m est appliqué pour éliminer les bulles « dures ».

Ces bulles dures sont en fait des bulles présentant une mobilité plus faible et qui suivent mal la direction imposée par le champ.

On connaît aussi une mémoire à bulles magnétiques dans laquelle la propagation des bulles est assurée par un dispositif comprenant une feuille électriquement conductrice présentant des fenêtres, et des motifs non implantés en forme de disques, de la couche de grenat magnétique. Ce dispositif est décrit dans l'article de H. OHTA intitulé « Current access Ion-implanted bubble device structure » correspondant à la conférence prononcée par l'auteur le 3 mars 1981 à Atlanta (International Conference on magnetism and magnetic materials). Dans ce type de dispositif, lorsque les conditions d'implantation ionique sont convenables, des parois chargées existent au bord d'un disque non implanté. Les bulles sont propagées à l'aide des champs magnétiques verticaux qui sont créés par les parois chargées liées à ces motifs et par un trou dans un feuillet de courant. Un courant tournant appliqué dans le feuillet permet le déplacement de bulles.

Les dispositifs de propagation qui utilisent des champs tournants, sont difficiles à mettre en œuvre. Les dispositifs connus qui utilisent des feuilles conductrices à fenêtres associées à des îlots non implantés et faisant intervenir un champ vertical de déplacement et un champ plan pour éliminer les bulles dures, ainsi que les dispositifs qui utilisent des champs verticaux et des courants tournants, nécessitent une puissance importante pour chaque propagation d'un élément binaire ou bit d'information.

L'invention a pour but de remédier aux inconvénients, que présentent les dispositifs de propagation utilisant des feuilles conductrices à fenêtres, associées à des motifs non implantés, notamment en réduisant le champ de propagation des bulles afin de réduire la puissance dissipée. Ces buts sont atteints en utilisant à la fois les composantes verticales (perpendiculaires au déplacement des bulles) et les composantes planes du champ intervenant dans le déplacement des bulles, grâce à une combinaison judicieuse de fenêtres dans des couches conductrices, associées à des motifs non implantés.

L'invention a pour objet une mémoire à bulles magnétiques comportant au moins une couche d'un grenat magnétique à implantation ionique, dans laquelle sont délimités des motifs correspondant à des zones non implantées de cette couche de grenat, des bulles magnétiques pouvant être formées dans la couche de grenat, sur les pourtours des motifs et une nappe électriquement conductrice superposée à la couche de grenat, isolée de celle-ci, cette nappe comportant deux couches conductrices isolées l'une de l'autre, chaque couche conductrice comportant des fenêtres pour déplacer chaque bulle du pourtour d'un motif au pourtour d'un autre motif, caractérisée en ce que les motifs sont des îlots séparés les uns des autres, ladite nappe comportant une première couche conductrice isolée de la couche de grenat par une première couche isolante, cette première couche conductrice comportant des fenêtres parallèles à une première direction pour déplacer respectivement les bulles existantes entre les motifs de premières paires de motifs disposés parallèlement à cette première direction, cette première couche conductrice recevant un courant impulsionnel de déplacement des bulles, parallèle à la première direction, et une deuxième couche conductrice superposée à la première couche conductrice et séparée de celle-ci par une deuxième couche isolante, cette deuxième couche conductrice comportant des fenêtres parallèles à une deuxième direction pour déplacer respectivement les bulles existantes entre les motifs de deuxièmes paires de motifs disposés parallèlement à cette deuxième direction, cette deuxième couche conductrice recevant un courant impulsionnel de déplacement des bulles, parallèle à la deuxième direction, chaque première paire présentant un motif commun avec chaque deuxième paire, deux fenêtres consécutives présentant une surface d'ouverture commune en regard de chaque motif commun, la première et la seconde directions n'étant pas parallèles entre elles.

Selon un mode de réalisation particulier, la première et la seconde directions sont perpendiculaires.

Selon un autre mode de réalisation particulier, les courants parcourant les première et deuxième couches conductrices ont une intensité telle que les composantes du champ magnétique, perpendiculaires au bord des fenêtres, créées par ces courants, engendrent des forces magnétiques supérieures à la coercitivité des bulles.

Les caractéristiques et avantages de l'invention ressortiront mieux de la description qui va suivre, donnée en référence aux dessins annexés dans lesquels :

la figure 1   représente schématiquement une vue de dessus d'un dispositif de propagation de bulles magnétigues, conforme à l'invention ;

la figure 2   représente la coupe A du dispositif de la figure 1,

la figure 3a   est une vue parallèle en coupe du dispositif, montrant les deux sens des composantes du champ plan,

la figure 3b   est un diagramme montrant la variation du champ de collapse des bulles, en fonction de l'amplitude du champ plan appliqué,

la figure 4a   est un diagramme montrant la variation de la force de transfert des bulles, en fonction de l'amplitude du champ plan,

la figure 4b   est un diagramme montrant la variation de la force d'accrochage des bulles, en fonction de l'amplitude du champ plan,

les figures 5a et 5b   sont des diagrammes montrant respectivement les variations de la force de transfert et de la force d'accrochage des bulles, en fonction de la température de la couche de grenat magnétique.

la figure 6   représente la variation du champ magnétique vertical, en regard d'une fenêtre de l'une des couches conductrices.

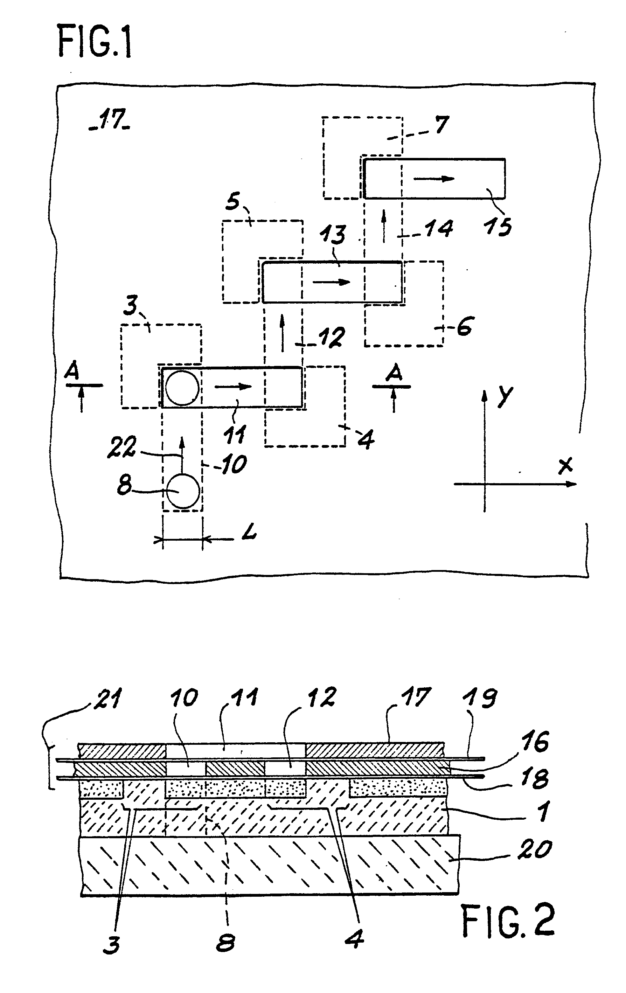

Les figures 1 et 2 représentent schématiquement une vue de dessus et une vue en coupe A du dispositif de propagation de bulles magnétiques, conforme à l'invention. Ce dispositif comporte au moins une couche 1 d'un grenat magnétique qui peut être par exemple constitué dans un matériau de formule $(YSmCuCa)_3 (FeGe)_5O_{12}$. La couche 1 de grenat magnétique est soumise à une implantation ionique ainsi qu'un recuit thermique. Cette implantation consiste à implanter dans la couche de grenat des ions $Ne^+$ par exemple sous l'action d'un champ électrique. La densité de ces ions peut être par exemple de $2 \times 10^{14}$ ions $Ne^+/cm^2$ et le champ électrique appliqué lors de cette implantation peut être de 200 KeV. Le recuit thermique de la couche de grenat magnétique peut être effectué à 700 °C. La couche 1 présente des motifs 3, 4, 5, 6, 7, ... correspondant à des zones non implantées du grenat. Des bulles magnétiques 8 sont formées dans la zone implantée de la couche 1 de grenat magnétique et elles circulent comme on le verra plus loin en détail, sur les pourtours des motifs non implantés 3, 4, 5, 6, 7, ainsi que dans des fenêtres 10, 12, 14, et 11, 13, 15, découpées respectivement dans une première couche conductrice 16 et dans une deuxième couche conductrice 17. La première couche conductrice 16 est superposée à la couche 1 de grenat magnétique et elle est séparée de celle-ci par une première couche 18 d'un matériau électriquement isolant. La deuxième couche conductrice 17 est superposée à la première couche et elle est séparée de celle-ci par une deuxième couche 19, d'un matériau électriquement isolant. Les fenêtres 10, 11, 12, de la figure 1 apparaissent aussi sur la figure 2. La couche 1 de grenat peut être supportée par un substrat 20 amagnétique de formule $Ge_3 Ga_5 O_{12}$ par exemple. Les couches électriquement conductrices 16, 17, forment une nappe 21 électriquement conductrice percée par les fenêtres 10, 11 ... 15. Ces fenêtres permettent de déplacer chaque bulle du pourtour d'un motif vers le pourtour d'un autre motif. Les motifs 3, 4, ... 7 ... forment des ilots séparés les uns des autres dans la couche 1 de grenat magnétique. Les bulles magnétiques 8 sont déplacées, comme on le verra plus loin en détail, par exemple dans le sens des flèches 22 grâce à des courants électriques impulsionnels appliqués respectivement aux première et deuxième couches conductrices 16, 17. La première impulsion de courant appliquée par exemple à la première couche conductrice 16 permet de déplacer la bulle 8 en direction du pourtour du motif non implanté 3. La première impulsion de courant appliquée à la deuxième couche conductrice 17 déplacera cette bulle en direction du pourtour du motif 4. Il en est de même pour le déplacement de cette bulle vers les pourtours des autres motifs représentés sur la figure 1.

Les fenêtres 10, 12, 14 ... de la première couche conductrice 16, sont parallèles à une première direction Y et permettent de déplacer respectivement des bulles existantes, entre les motifs de premières paires de motifs tels que 4, 5 et 6, 7. Les fenêtres telles que 11, 13 sont parallèles à une deuxième direction X par exemple, et permettent de déplacer les bulles existantes entre des deuxièmes paires de motifs tels que 3, 4 et 5, 6. Ces deuxièmes paires de motifs sont disposées parallèlement à une deuxième direction X.

Selon l'invention, deux fenêtres consécutives telles que 10, 11 par exemple présentent une surface d'ouverture commune en regard du motif commun correspondant 3. De préférence, les première et seconde directions Y et X sont perpendiculaires.

Comme on le verra plus loin en détail, les courants impulsionnels qui parcourent les première et deuxième couches conductrices 16, 17 ont une intensité telle que les composantes du champ magnétique, perpendiculaires aux bords des fenêtres, créées par ces courants, engendrent des forces magnétiques supérieures à la coercitivité des bulles.

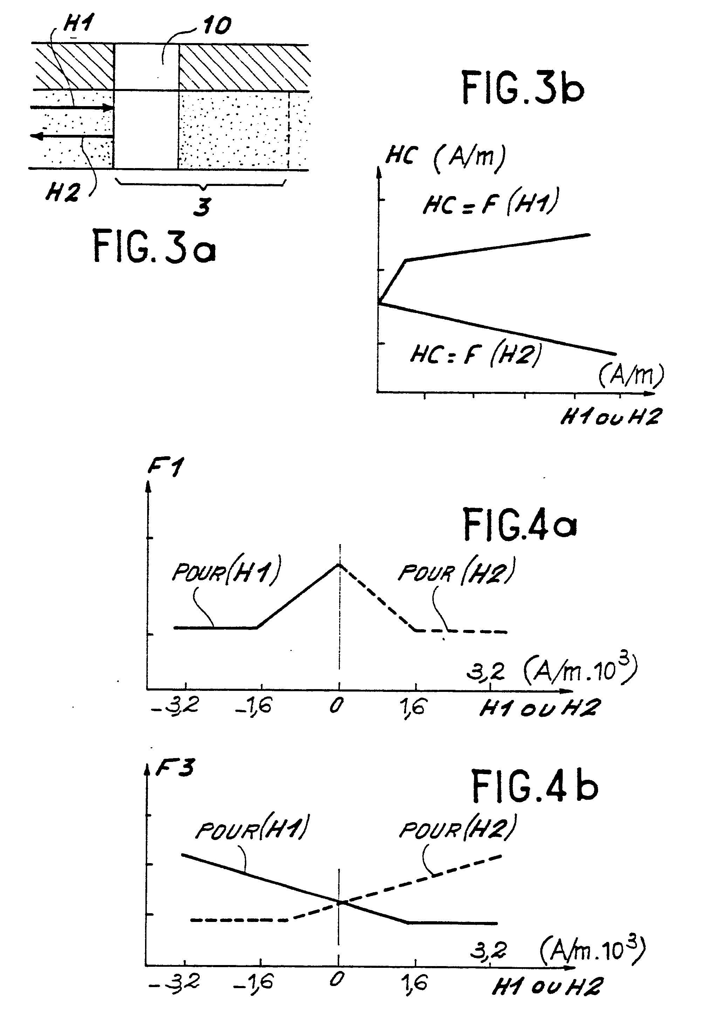

Les figures 3a et 3b permettent de mieux comprendre le fonctionnement du dispositif de l'invention. La figure 3a représente schématiquement les composantes $H_1$ ou $H_2$ du champ magnétique plan perpendiculaire au pourtour d'un motif non implanté 3 et créé par exemple par le passage d'une impulsion de courant dans la couche conductrice 16. Ce champ plan peut présenter l'une des deux directions $H_1$ ou $H_2$ et il est perpendiculaire au rebord de la fenêtre 10 par exemple.

La figure 3b est un diagramme qui représente la variation de l'amplitude du champ de collapse HC (ou champ de disparition d'une bulle), en fonction de l'amplitude et du sens du champ plan $H_1$ ou $H_2$. Sur ce diagramme, les champs sont exprimés en A/m.

Lorsque le champ plan est appliqué perpendiculairement à la bordure d'un motif non implanté rectiligne, il se développe le long de la bordure de ce motif, des charges magnétiques qui modifient les propriétés des bulles. Ces charges magnétiques provoquent l'apparition d'un champ de fuite vertical qui modifie le champ de collapse ou de disparition des bulles situées le long de la bordure du motif, ainsi que les pentes de la barrière de potentiel existant sur cette bordure. Ainsi, suivant le sens du champ plan, on observe une augmentation ou une diminution du champ de collapse ainsi qu'un effet attractif ou répulsif sur chaque bulle située le long de la bordure du motif.

La figure 4a est un diagramme qui représente la force de transfert $F_1$ d'une bulle, en fonction de l'amplitude et du sens du champ plan appliqué perpendiculairement à la bordure d'un motif non implanté. Sur ce diagramme, on a représenté en trait continu la force de transfert $F_1$ pour le champ plan $H_1$ et on a représenté cette force de transfert en traits discontinus pour le champ plan $H_2$ de sens opposé à $H_1$.

La figure 4b représente les variations de la force d'accrochage ou attractive $F_3$ d'une bulle en fonction de l'amplitude du champ plan et du sens de ce champ. Cette force est représentée en trait continu pour le champ plan de sens $H_1$ et elle est représentée en traits discontinus pour le champ plan de sens $H_2$. Le champ plan sur ce diagramme ainsi que sur le diagramme de la figure 4a, est exprimé en A/m.

Ces figures montrent que quand des charges répulsives apparaissent (aux environs de 20 Oersted dans l'exemple considéré), la force d'accrochage $F_3$ d'une bulle à la bordure d'un motif implanté, diminue avec l'amplitude du champ plan appliqué. La force de transfert $F_1$ diminue elle aussi avec l'amplitude du champ plan appliqué.

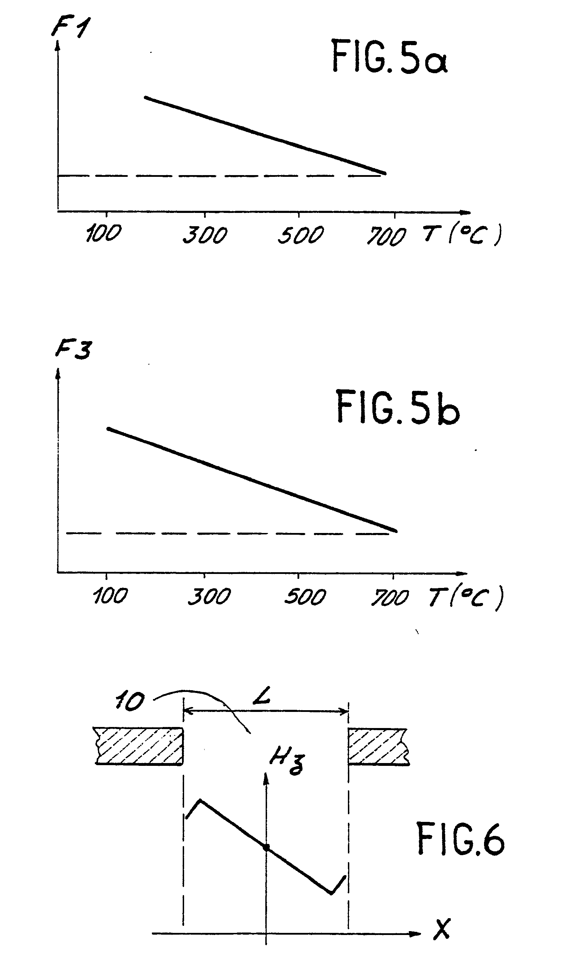

Les figures 5a et 5b sont des diagrammes qui représentent respectivement les variations de la force de transfert $F_1$ et de la force d'accrochage

$F_3$, en fonction de la température de recuit thermique de la couche de grenat magnétique. La ligne discontinue sur ce diagramme représente la coercitivité, c'est-à-dire la force minimale mécanique (frottement) qu'il est nécessaire d'appliquer à une bulle pour la déplacer. Les températures T de recuit sont exprimées en °C. La force d'accrochage $F_3$ ainsi que la contribution des charges magnétiques à cette force, dépendent des conditions d'implantation ionique et de recuit thermique. Le recuit thermique a pour effet de diminuer les forces d'accrochage exercées sur les bulles. Dans le grenat magnétique choisi en exemple, qui est implanté en présence d'un champ électrique de 200 KeV et pour un recuit effectué à 700°, la force d'accrochage est égale à la force de coercitivité dans une région uniformément implantée. Cette force exprimée en unité de champ magnétique est de $0,28 \cdot 10^3$ A/m environ, pour un champ plan de $2 \cdot 10^3$ A/m appliqué perpendiculairement à la bordure du motif non implanté ; dans ces conditions, la contribution des charges magnétiques à la force d'accrochage $F_3$ est d'environ $0,2 \cdot 10^3$ A/m. Lorsque les charges magnétiques sont répulsives, la force d'accrochage est d'environ $0,28-0,2 = 0,08 \cdot 10^3$ A/m. Le champ de propagation de la bulle est alors inférieur à celui de la coercitivité.

Dans le dispositif qui vient d'être décrit en exemple, les bulles ont un diamètre de 2 µ environ. Les motifs non implantés sont obtenus par masquage à l'aide d'une couche d'or, et le recuit thermique est effectué à 700 °C environ pendant une durée de 2 heures. Les couches conductrices dans lesquelles sont appliquées les impulsions permettant de faire circuler les bulles sont en or, tandis que les couches électriquement isolantes ont une épaisseur voisine de 150 nanomètres.

La propagation d'une bulle est obtenue par une impulsion de courant dans la couche conductrice 16, puis par une impulsion de courant dans la couche conductrice 17, et ainsi de suite selon le motif vers lequel on souhaite diriger chaque bulle.

La figure 6 représente la variation du champ magnétique HZ vertical en regard de l'une des fenêtres 10 de largeur L par exemple. Lorsque le champ magnétique vertical HZ a une valeur maximum, il existe des charges magnétiques répulsives sur les bordures du motif non implanté correspondant, tandis que lorsque le champ magnétique vertical HZ a une valeur minimun, ce sont des charges magnétiques attractives qui existent sur le bord de ce motif. L'apparition de ces charges attractives diminue le champ de propagation de la bulle.

La valeur du champ magnétique vertical peut être calculée facilement à partir de la valeur de la composante plane du champ, décrite plus haut ; cette composante plane est égale à $2 \pi \times J$ (J étant la densité linéaire de courant dans la couche conductrice considérée).

Les principaux avantages du dispositif de l'invention résident essentiellement dans le fait qu'il permet de diminuer le champ de propagation des bulles et donc la puissance dissipée dans les couches conductrices commandant cette propagation. Il permet d'éliminer les bulles dures, car toutes les bulles se propagent dans une zone implantée du grenat magnétique ; enfin, les bulles ont une position d'équilibre stable à l'arrêt et elles sont piégées à la bordure des motifs implantés.

**Revendications**

1. Dispositif de propagation de bulles magnétiques comportant au moins une couche (1) d'un grenat magnétique à implantation ionique, dans laquelle sont délimités des motifs (3, 4, ...) correspondant à des zones non implantées de cette couche de grenat, des bulles magnétiques (8) pouvant être formées dans la couche de grenat, sur les pourtours des motifs (3, 4, ...) et une nappe (21) électriquement conductrice superposée à la couche de grenat (1), isolée de celle-ci, cette nappe comportant deux couches conductrices isolées l'une de l'autre, chaque couche conductrice comportant des fenêtres (10, 11, 12, ...) pour déplacer chaque bulle du pourtour d'un motif au pourtour d'un autre motif, caractérisé en ce que les motifs (3, 4, ...) sont des îlots séparés les uns des autres, ladite nappe (21) comportant une première couche conductrice (16) isolée de la couche de grenat (1) par une première couche isolante (18), cette première couche conductrice comportant des fenêtres (10, 12, 14, ...) parallèles à une première direction (Y) pour déplacer respectivement les bulles existantes entre les motifs de premières paires de motifs (4, 5 et 6, 7) disposés parallèlement à cette première direction, cette première couche conductrice recevant un courant impulsionnel de déplacement des bulles, parallèle à la première direction, et une deuxième couche conductrice (17) superposée à la première couche conductrice (16) et séparée de celle-ci par une deuxième couche isolante (19), cette deuxième couche conductrice comportant des fenêtres (11, 13, 15, ...) parallèles à une deuxième direction (X) pour déplacer respectivement les bulles existantes entre les motifs de deuxièmes paires de motifs (3, 4 et 5, 6 ...) disposés parallèlement à cette deuxième direction, cette deuxième couche conductrice recevant un courant impulsionnel de déplacement des bulles, parallèle à la deuxième direction, chaque première paire (4, 5) présentant un motif (5) commun avec chaque deuxième paire (5, 6), les deux directions X et Y n'étant pas parallèles entre elles et deux fenêtres consécutives (10, 11, ...) présentant une surface d'ouverture commune en regard de chaque motif commun (3).

2. Dispositif selon la revendication 1, caractérisé en ce que les première et seconde directions (X, Y) sont perpendiculaires.

3. Dispositif selon la revendication 2, caractérisé en ce que les courants parcourant les première et deuxième couches conductrices ont une intensité telle que les composantes du champ magnétique, perpendiculaires au bord des fenêtres, créées par ces courants, engendrent des
forces magnétiques supérieures à la coercitivité
des bulles.

## Claims

1. Device for the propagation of magnetic bubbles including at least one layer (1) of an ionic
implantation magnetic garnet in which are outlined patterns (3, 4, ...) corresponding with non-
implanted areas of this layer of garnet, magnetic
bubbles (8) being able to be formed in the layer of
garnet, on the peripheries of the patterns (3, 4, ...)
and an electrically conducting sheet (21) superimposed on the layer of garnet (1), insulated from
this layer, this sheet including two conducting
layers insulated from each other, each conducting
layer including windows (10, 11, 12, ...) in order to
move each bubble from the periphery of one
pattern to the periphery of another pattern,
characterized in that the patterns (3, 4, ...) are
islands that are separate from each other, the said
sheet (21) including a first conducting layer (16)
insulated from the layer of garnet (1) by a first
insulating layer (18), this first conducting layer
including windows (10, 12, 14, ...) parallel with a
first direction (Y) for respectively moving the
existing bubbles between the patterns of first
pairs of patterns (4, 5 and 6, 7) arranged parallel
to this first direction, this first conducting layer
receiving a pulsed bubble-moving current, parallel to the first direction, and a second conducting
layer (17) superimposed on the first conducting
layer (16) and separated from it by a second
insulating layer (19), this second conducting layer
including windows (11, 13, 15, ...) parallel with a
second direction (X) in order to respectively move
the existing bubbles between the patterns of
second pairs of patterns (3, 4 and 5, 6) arranged
parallel with this second direction, this second
conducting layer receiving a pulsed bubble-moving current parallel with the second direction,
each first pair (4, 5) haing a pattern (5) which is
common with each second pair (5, 6) the two
directions X and Y not being parallel with each
other and two consecutive windows (10, 11, ...)
having a common aperture area facing each
common pattern (3).

2. Device according to Claim 1, characterized
in that the first and second directions (X, Y) are
perpendicular.

3. Device according to Claim 2, characterized
in that the currents flowing through the first and
second conducting layers have values such that
the components of the magnetic field, perpendicular to the edge of the windows, created by
these currents, generate magnetic forces greater
than the coercivity of the bubbles.

## Patentansprüche

1. Magnetische Blasen-Fortpflanzungsanordnung mit zumindest einer Schicht (1) aus einem
magnetischen Ionenimplantationsgranat, in der
Muster (3, 4, ...) begrenzt sind, die nicht implantierten Bereichen dieser Schicht aus Granat
entsprechen, wobei magnetische Blasen (8) in
der Granatschicht auf dem Umfang der Muster (3,
4, ...) bildbar sind, und mit einer elektrisch leitenden Schicht (21), die die Granatschicht (1)
überdeckt und von dieser isoliert ist, wobei diese
Schicht zwei voneinander isolierte, leitende
Schichten aufweist und jede leitende Schicht
Fenster (10, 11, 12, ...) besitzt, um jede Blase von
dem Umfang eines Musters zu dem Umfang eines
anderen Musters zu verschieben, dadurch gekennzeichnet, daß die Muster (3, 4, ...) voneinander getrennte Inseln sind, die Schicht (21) eine
erste, leitende Schicht (16), die von der Granatschicht (1) durch eine erste Isolierschicht (18)
isoliert ist, aufweist, wobei diese erste, leitende
Schicht Fenster (10, 12, 14, ...) aufweist, die
parallel zu einer ersten Richtung (Y) sind, um die
jeweils zwischen den parallel zu dieser ersten
Richtung angeordneten Mustern von ersten
Musterpaaren (4, 5 und 6, 7) vorhandenen Blasen
zu verschieben, und diese erste, leitende Schicht
einen Impulsstrom zum Verschieben der Blasen
parallel zu der ersten Richtung erhält, sowie eine
zweite, leitende Schicht (17) aufweist, die der
ersten, leitenden Schicht (16) überlagert und von
dieser durch eine zweite, isolierende Schicht
getrennt ist, wobei diese zweite, leitende Schicht
zu der zweiten Richtung (X) parallele Fenster (11,
13, 15, ...) umfaßt, um die jeweils zwischen den
parallel zu dieser zweiten Richtung angeordneten
Mustern von zweiten Musterpaaren (3, 4 und 5, 6)
vorhandenen Blasen zu verschieben und diese
zweite, leitende Schicht einen Impulsstrom zum
Verschieben der Blasen parallel zu der zweiten
Richtung erhält, daß jedes erste Paar (4, 5) ein mit
jedem zweiten Paar (5, 6) gemeinsames Muster
(5) aufweist, daß die zwei Richtungen (X und Y)
nicht parallel zueinander sind und zwei aufeinanderfolgende Fenster (10, 11, ...) eine jedem ge-
meinsamen Muster (3) gegenüberliegende ge-
meinsame Öffnungsoberfläche aufweisen.

2. Anordnung nach Anspruch 1, dadurch gekennzeichnet, daß die ersten und die zweiten
Richtungen (X, Y) senkrecht zueinander sind.

3. Anordnung nach Anspruch 2, dadurch gekennzeichnet, daß die die erste und die zweite,
leitende Schicht durchfließenden Ströme eine
solche Stärke aufweisen, daß die zu den Fensterrändern senkrechten, von diesen Strömen
erzeugten Magnetfeldkomponenten Magnetkräfte
erzeugen, die höher als die Koerzitivität der Blasen ist.

FIG.1

FIG.2

H1    10

FIG. 3b

FIG. 3a

HC (A/m)

HC = F (H1)

HC = F (H2)

(A/m)

H1 ou H2

F1

FIG. 4a

POUR (H1)    POUR (H2)

3,2 (A/m.10³)

-3,2    -1,6    0    1,6    H1 ou H2

F3

FIG. 4b

POUR (H1)    POUR (H2)

3,2 (A/m.10³)

-3,2    -1,6    0    1,6    H1 ou H2

F1

FIG.5a

100    300    500    700    T (°C)

F3

FIG.5b

100    300    500    700    T (°C)

10    L    H3

FIG.6

X